(19) Europäisches Patentamt
European Patent Office
Office européen des brevets

(11) **EP 3 737 952 B1**

(12) **EUROPÄISCHE PATENTSCHRIFT**

(45) Veröffentlichungstag und Bekanntmachung des Hinweises auf die Patenterteilung:
**09.03.2022 Patentblatt 2022/10**

(21) Anmeldenummer: **19700225.6**

(22) Anmeldetag: **08.01.2019**

(51) Internationale Patentklassifikation (IPC):
***G01R 15/20*** *(2006.01)* ***G01R 15/14*** *(2006.01)*
***G01R 19/00*** *(2006.01)*

(52) Gemeinsame Patentklassifikation (CPC):
**G01R 15/207; G01R 15/205;** G01R 19/0092

(86) Internationale Anmeldenummer:
**PCT/EP2019/050324**

(87) Internationale Veröffentlichungsnummer:
**WO 2019/137902 (18.07.2019 Gazette 2019/29)**

(54) **MEHRPHASEN-STROMMESSVORRICHTUNG UND VERFAHREN ZUR MEHRPHASENSTROMMESSUNG**

MULTIPHASE CURRENT MEASURING APPARATUS AND METHOD FOR MULTIPHASE CURRENT MEASUREMENT

DISPOSITIF DE MESURE DE COURANT POLYPHASÉ ET PROCÉDÉ DE MESURE DE COURANT POLYPHASÉ

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **12.01.2018 DE 102018100689**

(43) Veröffentlichungstag der Anmeldung:
**18.11.2020 Patentblatt 2020/47**

(73) Patentinhaber: **Sensitec GmbH**
**35633 Lahnau (DE)**

(72) Erfinder:
• **BRUSIUS, Matthias**
**35080 Hartenrod (DE)**

• **GLENSKE, Claudia**
**35638 Leun (DE)**

(74) Vertreter: **Spachmann, Holger**
**Stumpf Patentanwälte PartGmbB**
**Alte Weinsteige 73**
**70597 Stuttgart (DE)**

(56) Entgegenhaltungen:
EP-A1- 3 141 913     EP-A2- 0 597 404
EP-B1- 0 874 244     DE-A1- 10 043 171
US-A1- 2012 187 943

## Beschreibung

Die Erfindung betrifft eine Strommessvorrichtung zur Messung von Strömen eines Mehrleiterstromsystems mit $N$ Stromleitern mit $N>2$ und $N-1$ magnetoresistiven Gradientensensoren sowie ein diesbezügliches Messverfahren, insbesondere für die Hochstrommessung.

STAND DER TECHNIK

Aus dem Stand der Technik ist bereits ein Verfahren und eine Mehrphasen-Strommessvorrichtung bekannt, die mittels magnetoresistiven Gradientensensoren eine magnetische Feldstärkedifferenz in einer Messebene zwischen Leiterströmen benachbarter Stromleiter misst.

So sind in der DE 197 48 550 A1 und der EP 0 874 244 B1 ein Verfahren und eine Mehrphasen-Strommessvorrichtung beschrieben, bei der elektrische Ströme in $N$ Leitern mit $N-1$ magnetoresistiven Gradientensensoren gemessen werden können. Hierdurch kann ein kompakter Aufbau einer Strommessvorrichtung erreicht werden, wobei ausgehend von einer Gradientenmagnetfeldmessung zwischen jeweils benachbarten Stromleitern bei $N$ Stromleitern und $N-1$ Gradientensensoren eine Bestimmung des Gesamtstroms möglich wird. Hierzu wird explizit auf den Offenbarungsgehalt der vorgenannten Druckschriften hingewiesen, die das Prinzip der differenziellen Strommessung, das auch dieser Erfindung zugrunde liegt, näher erläutern.

In der DE 197 48 550 A1 ist ein Verfahren zum Messen von elektrischen Strömen in n Leitern sowie Vorrichtung zur Durchführung des Verfahrens dargestellt. Eine Messung der Ströme in den n Leitern wird mit n-1 magnetoresistiven Sensoren durchgeführt, wobei die Sensoren als Gradiometer zur Messung der von einem Leiterstrom oder mehreren Leiterströmen erzeugten magnetischen Feldstärkedifferenzen ausgebildet sind.

In der EP 0 597 404 A2 ist ein Verfahren und eine Einrichtung zur Ermittlung der Leiterströme eines Mehrleitersystems dargestellt. Das Verfahren basiert auf einer messtechnischen Erfassung vektorieller magnetischer Feldstärken in Summenmagnetfeld eines Mehrleitersystems. Die einzelnen Leiterströme werden auf der Grundlage der gemessenen Feldstärken berechnet. Eine Messanordnung zur Durchführung des Verfahrens umfasst eine der Leiterzahl äquivalente Anzahl von Sensoren oder im Falle eines Drehstromsystems auch nur zwei Sensoren, die im Summen-magnetfeld nahe am Dreileitersystem und innerhalb einer magnetischen Abschirmeinrichtung angeordnet sind und mit einer Auswerteeinrichtung verbunden sind.

DE 100 43 171 A1 offenbart einen Stromdetektor, der aus einem zu messenden Leiter, einem ersten Hall-Element und einem zweiten Hall-Element besteht.

EP 3 141 913 A1 offenbart eine Messvorrichtung, in der eine Leiteranordnung angeordnet ist.

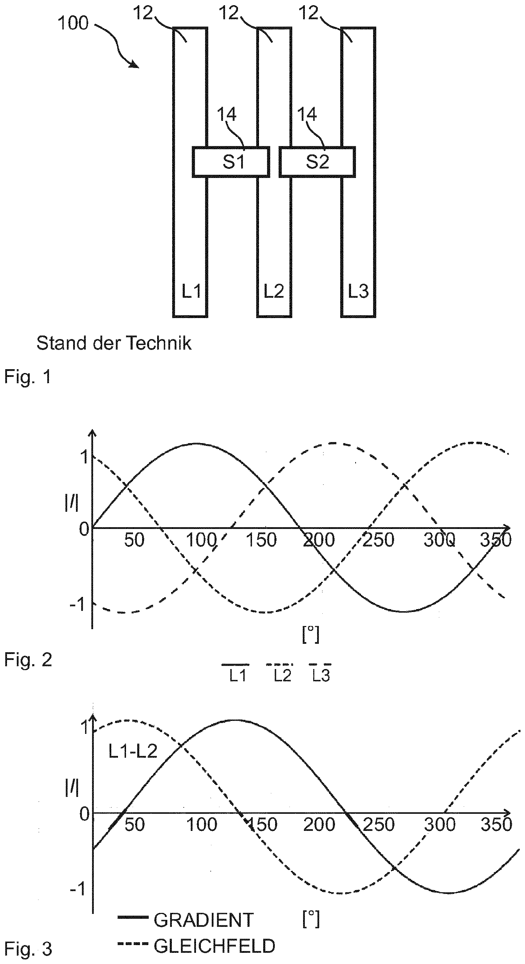

Allerdings hat sich beim praktischen Einsatz gezeigt, dass die vorbekannte Strommessvorrichtung insbesondere bei Messung hoher Ströme, die mehrere hundert Ampere pro Stromleiter erreichen können, fehleranfällig ist. So zeigt sich beispielsweise bei Anwendung der in den vorgenannten Druckschriften gezeigten Strommessvorrichtung eine hohe Ungenauigkeit bei Messung von Strömen über 600 A im Peak in einem Dreileitersystem, so dass für Strommessungen >100-500 A Peakstrom pro Stromphase das vorgenannte Verfahren praktisch nicht einsetzbar ist. Der ursächliche Grund liegt darin, dass im praktischen Einsatz versucht wird, die Messvorrichtung möglichst kompakt auszuführen. Bei einer derartig hochkompakten Strommessvorrichtung, wie sie beispielsweise in Fig. 1 dargestellt ist, sind die Abstände zwischen den einzelnen Stromleitern 12 derart gering, dass ein Gleichfeld zwischen benachbarten Stromleitern 12, der durch einen in die gleiche Richtung gerichteten Strom in beiden Stromleitern hervorgerufen wird, den Arbeitspunkt des Gradientensensors 14 in einen nichtlinearen Kennlinienbereich verschiebt, so dass es bei hohen Strömen oberhalb von 100 A im Peak zu deutlichen Verzerrungen und Ungenauigkeiten der Strommessung kommt.

Vergrößert man hingegen die Abstände zwischen den einzelnen Stromleitern, so verringert sich das Gradientenfeld, was wiederum zu ungenauen Messergebnissen führt. Hierdurch wird weiterhin der Bauraum stark erhöht, wobei für viele Anwendungen eine Vergrößerung der Messfläche nicht infrage kommt.

Ein maximales Gleichfeld tritt immer dann ein, wenn bei benachbarten Stromleitern, zwischen denen ein Gradientensensor angeordnet ist, der Strom in gleicher Stärke und gleicher Richtung getragen wird. Übersteigt das Gleichfeld deutlich den Feldgradienten, kann eine Kennlinie eines Gradientensensors in einen nichtlinearen Bereich verschoben werden, in dem ein Stromgradient nicht exakt bestimmt werden kann. Insbesondere bei Drehfeldanwendungen von drei der mehr Phasen kann dies während einer Periode mindestens zwei oder mehrmals auftreten. Eine Kompensationseinrichtung, die mittels einer closed-loop Regelung ein Gegenmagnetfeld aufbaut, um die Einwirkung eines Gleichfelds zu kompensieren, kann bei den vorgenannt hohen Stromwerten keine ausreichende Ausregelung erreichen, so dass es zu nichtlinearen Verzerrungen in den Messergebnissen kommt.

Ausgehend von oben genanntem Stand der Technik ergibt sich somit das Problem, dass bei Anwendung von magnetoresistiven Gradientensensoren zur Strombestimmung in $N$ Stromleitern mittels $N-1$ Gradientensensoren bei Überschreiten einer bestimmten Stromstärke Verzerrungen auftreten können, die einen Einsatz für Hochstromanwendungen in einem Mehrphasenstromsystem unmöglich machen.

**EP 3 737 952 B1**

Aufgabe der vorliegenden Erfindung ist es daher, die vorgenannten Probleme zu lösen, und die vorbekannte Strommessvorrichtung dahin gehend zu verbessern, dass auch bei Hochstromanwendungen eine exakte und genaue Strommessung auch bei kompakter Bauweise der Strommessvorrichtung ermöglicht werden kann.

Diese Aufgabe wird durch eine Strommessvorrichtung und ein Strommessverfahren nach den unabhängigen Ansprüchen gelöst.

Vorteilhafte Ausführungen der Erfindung sind Gegenstand der Unteransprüche.

OFFENBARUNG DER ERFINDUNG

Die Erfindung geht aus von einer Mehrphasen-Strommessvorrichtung zur Messung von Strömen eines Mehrleiterstromsystems mit $N$ Stromleitern und $N>2$, umfassend $N$-1 magnetoresistive Gradientensensoren zur Bestimmung einer magnetischen Feldstärkedifferenz in einer Messebene zwischen Leiterströmen benachbarter Stromleiter.

Es wird vorgeschlagen, dass bezüglich jedes magnetoresistiven Gradientensensors zur Kompensation einer Gleichfeldkomponente der beiden benachbarten Stromleiter, zumindest ein Bypassleiter zumindest eines der weiteren Stromleiter angeordnet ist.

Mit anderen Worten wird eine an sich bekannte Mehrphasen-Strommessvorrichtung vorgeschlagen, die eine Mehrzahl von Stromleitern aufweist, wobei jeweils zwischen zwei benachbarten Stromleitern ein magnetoresistiver Gradientensensor angeordnet ist. Der Gradientensensor misst ein magnetisches Differenzfeld zwischen den beiden benachbarten Stromleitern. Fließen betragsgleiche Gleichströme in den beiden Stromleitern in dieselbe Richtung, so wird kein Gradientenfeld gemessen. Fließen verschieden hohe Ströme oder Ströme in verschiedenen Richtungen zwischen den beiden Stromleitern, so wird ein entsprechend höheres magnetisches Differenzfeld gemessen. Die grundsätzliche Wirkungsweise einer derartigen Strommessvorrichtung ist bereits im Stand der Technik bekannt.

Bei hohen Strömen und im Falle einer hohen gleichgerichteten Stromkomponente der beiden benachbarten Stromleiter ergibt sich ein hohes magnetisches Gleichfeld am Gradientensensor, das zwar keinen magnetischen Gradienten hervorruft, jedoch den linearen Arbeitspunkt des Gradientensensors in einen nichtlinearen Bereich verschieben kann, zumindest wenn die Gleichfeldkomponente deutlich höher als eine Differenzfeldkomponente der parallelen Phasenströme ist. Zur Kompensation von nichtlinearen Verzerrungen wird erfindungsgemäß vorgesehen, dass zumindest ein Bypassleiter zumindest eines weiteren Stromleiters, der nicht benachbart zum Gradientensensor, sondern weiter entfernt angeordnet ist, in den Bereich des Gradientensensors geführt wird, so dass die entstehende Gleichfeldkomponente der beiden benachbarten Stromleiter hierdurch kompensiert werden kann.

So kann beispielsweise in einem Dreiphasensystem zwischen zwei Stromphasen L1 und L2 ein exakt gleich großer Strom in der gleichen Richtung bei Phasenwinkeln 30° und 210° auftreten, wie dies in Fig. 3 dargestellt ist. Zu diesen Phasenwinkeln würde ein Gradientensensor, der zwischen den beiden Stromphasen L1 und L2 angeordnet ist, eine hohe Gleichfeldkomponente (commonmode component) sehen, der einen linearen Arbeitsbereich des Sensors in einen nichtlinearen verzerrten Bereich verschieben würde. Bei hohen Strömen, die beispielsweise höher als mehrere hundert Ampere Peak, insbesondere höher als 600 A Peak betragen können, ist eine Hochstrommessung damit praktisch nicht durchführbar. An diesen Phasenpunkten fließt gleichzeitig ein entgegengesetzter Strom durch die übrigen Stromleiter zurück, da sich nach dem ersten Kirchhoffschen Gesetz die Summe aller Ströme zu Null ergibt, und erzeugt darin ebenfalls eine - entgegengesetzt gerichtete - Gleichfeldkomponente, so dass sich in Summe alle Gleichfeldkomponenten ausgleichen. Wird von zumindest einem, insbesondere allen übrigen Stromleitern ein Bypassleiter in die Nähe des Gradientensensors gebracht, so kann das herrschende Gleichfeld des Gradientensensors deutlich herabgesetzt werden und somit ein linearer Arbeitsbereich beibehalten werden. Hierdurch ist eine Messung auch von hohen Stromanteilen ohne lineare Verzerrung damit exakt möglich.

In einer vorteilhaften Ausführungsform der Mehrphasen-Strommessvorrichtung kann zumindest ein Bypassleiter oder eine Gruppe von Bypassleitern symmetrisch bezüglich der Messebene des magnetoresistiven Gradientensensors angeordnet sein. Hiermit kann erreicht werden, dass ein durch den zumindest einen Bypassleiter oder der Gruppe von Bypassleitern erzeugtes Bypassmagnetfeld kein Gradientenmesssignal des magnetoresistiven Gradientensensors bewirkt. In der Regel ist ein magnetoresistiver Gradientensensor derart ausgeführt, dass zwei räumlich definierbare Bereiche identifiziert werden können, zwischen denen ein magnetisches Gradientenfeld, d. h. eine Abweichung zwischen dem zwischen diesen Bereichen wirkenden magnetischen Feld gemessen werden kann. Daneben ist ein räumlicher Bereich in der Messebene definierbar, in dem ein Gradientensensor keinen Unterschied messen kann, da dieser Bereich symmetrisch zu den Gradientenbereichen des magnetoresistiven Sensors liegt. Es ist ein sogenannter neutraler Bereich der Messebene, in der ein symmetrisches Magnetfeld keine Auswirkungen auf ein Gradientenmesssignal des Gradientensensors bewirkt. Da es erfindungsgemäß um eine Unterdrückung einer Gleichfeldkomponente des Magnetfeldes geht, die zwischen zwei in den Gradientenbereichen wirkenden Stromleitern besteht, ist es besonders vorteilhaft, den Bypassleiter, der zur Reduktion des Gleichanteils des Gradientenmagnetfeldes dient, in diesem sogenannten neutralen Bereich der Messebene, also symmetrisch bezüglich der Messebene des magnetoresistiven Gradientensensors zu legen. Ein darin wirkendes Magnetfeld bewirkt somit keine Änderung des Gradientenmesssignals, wirkt allerdings eliminierend oder reduzierend auf die Höhe einer Gleichfeldkomponente des Magnetfelds, das zwischen den beiden Stromleitern, die in den Gradientenbereichen liegen, entsteht. Somit lässt sich ohne Beeinflussung des Gesamtmesssignals eine Reduktion der Gleichfeldkomponente und somit eine Überführung des Messbereichs des Gradientensensors in einen linearen Bereich ermöglichen.

In einer vorteilhaften Ausführungsform kann der durch einen Bypassleiter eines Stromleiters führbare Stromanteil eines Leiterstroms des Stromleiters einstellbar sein, insbesondere durch eine Querschnittsreduzierung, einen Isolationsbereich und/oder einen Widerstandsbereich des von dem Bypassleiter umgangenen Abschnitts des Stromleiters einstellbar sein. Zur effektiven Einstellung des durch den Bypassleiter fließenden Stroms, der dazu dienen soll, eine Gleichfeldkomponente des Gradientenfeldes zwischen zwei benachbarten Stromleitern zu reduzieren, ist es vorteilhaft, die Strommenge des Bypassleiters festzulegen, insbesondere eine Eichung bezüglich eines vorbestimmbaren Hochstrommessbereichs vorzunehmen. Hierzu kann die Strommenge dadurch festgelegt werden, dass im Leiterabschnitt des Stromleiters, dessen Strom durch den Bypassleiter abgeführt und an einen der benachbarten Stromleiter im Bereich des dort angesiedelten Gradientensensors geführt werden soll, eine Widerstandsbeeinflussung vorgenommen wird. Diese Widerstandsbeeinflussung, die direkt einen Einfluss auf den Stromanteil hat, der durch den Bypassleiter fließt, kann beispielsweise durch eine Reduktion des Querschnitts des Stromleiters, der vom Bypassleiter umgangen wird, vorgenommen werden. Es ist auch möglich, einen Isolationsbereich vorzusehen, beispielsweise durch ein Ausstanzen oder Ausnehmen von Material in dem vom Bypassleiter umgangenen Bereich. Auch ist es möglich, in diesem Bereich ein Material mit einem erhöhten Widerstand einzusetzen, beispielsweise Aluminium anstelle von Kupfer oder eine geeignete Legierung mit einem geringfügig geringeren Leitwert als die Bypassleitung, so dass der Anteil des Stroms, der prozentual nicht durch den Leiterabschnitt, sondern durch den Bypassleiter fließt, eingestellt werden kann. In der Regel ist die Stromstärke durch den Bypassleiter deutlich geringer als die Stromstärke durch den vom Bypassleiter umgangenen Stromleiteranteil. Beispielsweise können 20 %, bevorzugt 10 % oder weniger des durch den Stromleiter geführten Stroms durch den Bypassleiter geführt werden. So ist nur eine geringfügige Erhöhung des Widerstands im Stromleiterbereich notwendig, der vom Bypassleiter umgangen wird.

In einer weiteren vorteilhaften Ausführungsform können alle magnetoresistiven Gradientensensoren der Strommessvorrichtung entlang einer orthogonalen Achse zur Längserstreckung der Stromleiter angeordnet sein. In dieser Ausführungsform kann eine orthogonale Achse durch alle Stromleiter, die ein Mehrphasensystem umfasst, gelegt werden. Entlang dieser orthogonalen Achse werden die Gradientensensoren benachbart und parallel zueinander zwischen jeweils zwei Stromleitern angeordnet. Hiermit ergibt sich ein symmetrischer Aufbau aller Feldgradientensensoren, die benachbart nebeneinanderliegen, und jeweils zwei parallel verlaufende Stromleiter, die direkt benachbart sind, überdecken. Alle Feldgradientensensoren sind entlang einer Achse, die rechtwinklig zu den Stromleitern ausgerichtet ist, angeordnet, wodurch gleichartige Verhältnisse geschaffen werden können.

Alternativ zur vorgenannten Ausführungsform ist es ebenfalls vorteilhaft, dass die magnetoresistiven Gradientensensoren zur Längserstreckung des Stromleiters versetzt angeordnet sind. In der vorgenannten Ausführungsform ergibt sich nämlich das Problem, dass die Bypassleiter von jeweils nicht direkt benachbarten Stromleitern entlang der orthogonalen Achse jeweils unter den Feldgradientensensoren zu verlaufen haben. Hierdurch ergibt sich eine Vielzahl von Überlappungen der Bypassleiter zueinander, so dass ein mehrlagiger Aufbau oder eine komplexe Stromleiterführung der Bypassleiter notwendig wird. Durch eine in Längserstreckung der Stromleiter versetzte Anordnung der Gradientensensoren kann eine Überschneidung der Bypassleiter vermieden werden. Dadurch wird zwar die Strommessvorrichtung in Längserstreckung der Stromleiter räumlich verlängert, jedoch kann eine kompaktere Bauweise erreicht und ein mehrschichtiger Aufbau der Bypassleiterführung vermieden werden.

Somit können die beiden vorgenannten Ausführungsformen entweder für ein kompaktes Design oder für einen komplexen Aufbau und eine symmetrische Ausführungsform gewählt werden, und je nach Einsatzgebiet entsprechend konfiguriert werden.

In einer vorteilhaften Ausführungsform der Erfindung können die Gradientensensoren oberhalb einer Isolatorschicht und die Stromleiter und/oder die Bypassleiter unterhalb der Isolatorschicht angeordnet sein, wobei bevorzugt ein Zuführungsleiter der Bypassleiter oberhalb der Isolatorschicht geführt ist. In dieser Weiterbildung wird ein zumindest zweilagiger Aufbau der Strommessvorrichtung vorgeschlagen, wobei eine Isolatorschicht, beispielsweise ein PCB oder eine sonstige Isolatorschicht verwendet wird, und auf deren Unterseite die Stromleiter geführt werden können. Auch die Bypassleiter, die sich unterhalb der magnetoresistiven Gradientensensoren befinden, können unterhalb der Isolatorschicht geführt werden. Oberhalb der Isolatorschicht werden die Gradientensensoren aufgesetzt, die jeweils zwischen zwei benachbarten Stromleitern angeordnet sind, und in dessen Bereich jeweils zumindest ein Bypassleiter parallel zu den Stromleitern geführt ist. Die Bypassleiter sind elektrisch an einen weiteren, nicht unmittelbar benachbarten Stromleiter angeschlossen. Die Zuführungsleiter zu diesem weiteren Stromleiter können beispielsweise oberhalb der Isolatorschicht geführt sein, so dass ein in der Technik üblicher zweischichtiger Aufbau eines PCBs eingesetzt werden kann. Hierdurch ergibt sich eine kostengünstige und technologisch einfach herstellbare Mehrphasen-Strommessvorrichtung.

In einer weiteren bevorzugten Ausführungsform können die Zuführungsleiter der Bypassleiter in unterschiedlichen Leitungsebenen unterhalb und/oder oberhalb der Messebene der magnetoresistiven Gradientensensoren und der Stromleiter verlaufen, und die Bypassleiter im Wesentlichen in der Ebene der Stromleiter und parallel zu den Stromleitern verlaufen. In dieser Ausführungsform wird vorgeschlagen, dass sowohl die Stromleiter als auch die Bypassleiter in derselben Ebene und parallel zueinander verlaufen. Die Zuführungsleiter, die in der Regel rechtwinklig zu den Stromleitern und zu den Bypassleitern angeordnet sein können, können in unterschiedlichen Leitungsebenen unterhalb oder oberhalb dieser Messebene angeordnet, so können diese beispielsweise weiterhin unterhalb der Stromleiter und/oder oberhalb der Stromleiter, beispielsweise auf Höhe der Gradientensensoren angeordnet sein. Hierdurch wird ein mehrlagiger Aufbau vorgeschlagen, der insbesondere dann eingesetzt werden kann, wenn alle Gradientensensoren entlang einer orthogonalen Achse zu den Stromleitern angeordnet sind, da in diesem Fall zumindest zwei oder mehrere Bypassleiter mit Zuführungsleitern kontaktiert werden und die Zuführungsleiter jeweils einen weiteren Bypassleiter kreuzen. Somit kann ein zwei-, drei- oder mehrlagiger Aufbau der Strommessvorrichtung sinnvoll sein, um ein kompaktes Design zu erreichen. Ein weiterer Vorteil eines mehrlagigen Aufbaus ergibt sich dadurch, dass der Zuführungsleiter somit weiter entfernt von den Feldgradientensensoren ist, und deren parasitäres Magnetfeld einen verringerten Einfluss auf die Messwerte der Gradientensensoren haben kann.

In einer weiteren vorteilhaften Ausführungsform können mehrere Bypassleiter horizontal oder vertikal benachbart bezüglich der Messebene des magnetoresistiven Gradientensensors angeordnet sein. Die Messebene der magnetoresistiven Gradientensensoren ist die Ebene, in der die beiden parallel geführten Stromleiter geführt sind, zwischen denen ein Gradientenfeld zu messen ist. Vorzugsweise ist in dieser Messebene auch der Bypassleiter geführt, der sich jedoch in einer symmetrischen Anordnung bezüglich der Gradientenbereiche, die vom Gradientensensor erfasst werden, befindet. In dieser Ausführungsform wird vorgeschlagen, dass im Falle einer Mehrphasen-Strommessvorrichtung mit $N>3$ Stromleitern, wobei bezüglich dieser für jeden Gradientensensor zumindest zwei oder mehrere Bypassleiter notwendig werden, diese Bypassleiter entweder horizontal oder vertikal zueinander benachbart oder konzentrisch zueinander und zu dieser Messebene symmetrisch zum Gradientensensor angeordnet sein können. Somit wird vorgeschlagen, dass die Bypassleiter in der Messebene entweder parallel benachbart zueinander oder gestapelt übereinander oder in Form einer mehrlagigen Koaxalanordnung unterhalb des Gradientensensors in dessen neutralen Messbereich geführt sein können, so dass Gleichfeldkomponenten durch die verschiedenen Bypassleiter kompensiert werden können. Es wird somit ein Kompensationsmagnetfeld durch die Bypassleiter erzeugt, dass dadurch bewirkt wird, dass die parallel benachbarten Bypassleiter mit den verschiedenen Bypassströmen der nicht unmittelbar benachbarten Stromleiter durchflossen werden. Diese Leiter können parallel zueinander entweder innerhalb der Messebene oder aufeinandergeschichtet oder koaxial durch den neutralen Bereich der Messebene verlaufen. Vorzugsweise kann angedacht werden, dass die Bypassleiter konzentrisch zueinander geführt werden, d. h., beispielsweise wie in Form eines mehrschichtigen Koaxialkabels geführt werden, um ein Summenmagnetfeld in dem sensorneutralen Bereich des Gradientensensors zu erzeugen.

In einer weiteren vorteilhaften Ausführungsform kann der magnetoresistive Gradientensensor eine, bevorzugt einstellbare, Feldkompensationseinrichtung umfassen. Es ist hierzu denkbar, dass der Gradientensensor neben dem Bypassleiter eine aktive Feldkompensationseinrichtung umfasst, die es ermöglicht, durch Anlegen eines steuerbaren Kompensationsstroms ein gleichsam auf das Messwertsignal und auf die Gleichfeldkomponente wirkendes neutrales Kompensationsfeld im Gradientensensor aufzubauen, so dass die Gleichfeldkomponente zwischen den beiden Leitern eliminiert werden kann. Somit kann zusätzlich zu den Bypassleitern der Gradientensensor aktiv hinsichtlich einer Kompensation des Messwertbereichs durch eine Gleichfeldkomponente angesteuert werden, wobei sich hierzu eine closed-loop Regelung des Kompensationsmagnetfelds empfiehlt. Dabei kann es vorteilhaft sein, dass die Feldkompensationseinrichtung ein Gleichfeld, oder auch ein zeitlich veränderliches Feld, das sich an der Netzfrequenz des Mehrphasenstromnetzes orientiert, erzeugt. Durch die Feldkompensationseinrichtung kann weiterhin eine Anpassung des Messwertbereichs vorgenommen werden, so dass auch verschiedene Größenordnungen von Strömen exakt gemessen werden können, ohne dass Verzerrungen und Ungenauigkeiten bei der Strommessung auftreten, so dass ein hoher Dynamikbereich der Strommessung erreicht werden kann.

In einer vorteilhaften Ausführungsform können die Stromleiter und/oder die Bypassleiter einzeln oder gemeinsam in einer Ferritstruktur umfasst sein, um eine Magnetflussrichtung vorzugeben. Die Ferritstruktur umhüllt dabei zumindest bereichsweise die Stromleitung und/oder die Bypassleiter und führt deren Magnetfeld gezielt in den Messbereich des Gradientensensors, so dass gerade bei räumlich verteilten Bypassleitern eines Mehrphasen-Stromsystems mit mehr als drei Phasen die Magnetfelder der Bypassleiter in den gradientneutralen Bereich des Feldgradientensensors geführt werden können und parasitäre Felder abgeschirmt werden können. Auch können Streufelder dadurch eliminiert und die Feldgenauigkeit deutlich erhöht werden, so dass eine Verbesserung der Messgenauigkeit erreicht werden kann.

In einer vorteilhaften Ausführungsform können drei Stromleiter und zwei magnetoresistive Gradientensensoren umfasst sein. Somit wird vorgeschlagen, die Strommessvorrichtung insbesondere für ein Dreiphasensystem auszulegen, bei denen jeweils nur ein Bypassleiter unter einen der beiden Gradientensensoren geführt wird. Hierdurch ergeben sich bauliche Vereinfachungen und der Bypassleiter kann exakt in den feldneutralen mittleren Bereich symmetrisch durch den Gradientensensor gelegt werden, so dass eine sehr gute Kompensation von Gleichfeldanteilen in einem Hochstrom-Dreiphasensystem erreicht werden kann.

In einem nebengeordneten Aspekt wird ein Verfahren zur Mehrphasen-Strommessung bevorzugt unter Verwendung einer Mehrphasen-Strommessvorrichtung, wie oben beschrieben, vorgeschlagen, wobei $N$-1 magnetoresistive Gradientensensoren zur Messung von $N$ Leiterströmen mit $N>2$ eingesetzt werden, und zur Bestimmung einer magnetischen Feldstärkedifferenz in einer Messebene zwischen Leiterströmen benachbarter Stromleiter jeweils ein magnetoresistiver Gradientensensor mit einer Messebene zwischen zwei benachbarten Stromleitern angeordnet ist. In dem Verfahren wird vorgeschlagen, dass zur Unterdrückung einer Gleichfeldkomponente der Leiterströme der beiden benachbarten Stromleiter ein Bypassstrom zumindest eines weiteren Stromleiters, bevorzugt Bypassströme aller weiterer Stromleiter symmetrisch zur Messebene des magnetoresistiven Gradientensensors geführt werden.

Somit wird erfindungsgemäß vorgeschlagen, einen oder mehrere Bypassströme von allen weiteren an dem Mehrphasensystem beteiligten Stromleitern durch einen messwertneutralen Bereich des Gradientensensors zu führen, der in der Regel einer Symmetrieachse durch den Gradientensensor entspricht, so dass keine Gradientenwirkung durch das Bypassmagnetfeld, das von den Bypassströmen erzeugt wird, entsteht. Hierdurch wird das Messergebnis des Gradientensensors durch die Bypassströme nicht beeinflusst. Treten in den zwei benachbarten Stromleitern, die vom Gradientensensor erfasst werden, ein hoher Gleichstromanteil auf, der in gleicher Höhe und gleicher Richtung fließt, so fließen in den übrigen beteiligten Stromleitern des Mehrphasenstromsystems die Summe dieser Ströme zurück. Ein gebildeter Bypassstrom, der aus einer Magnetfeldkombination aller Bypassströme der weiteren beteiligten Leitern zustande kommt, bewirkt eine Kompensation dieses Gleichfeldes, so dass der Gradientensensor keinem hohen Gleichfeld ausgesetzt ist. Hierdurch ist es möglich, in einfacher konstruktiver Art und Weise Gleichfeldkomponenten in Hochstromanwendungen zu vermeiden, so dass eine exakte Messung der vorgeschlagenen Mehrphasen-Strommessvorrichtung erreicht werden kann.

In einer vorteilhaften Weiterbildung des Messverfahrens kann die Größe des oder der Bypassströme durch eine Veränderung des Widerstands eines vom Bypassleiter umgangenen Abschnitts des Stromleiters eingestellt werden. Diese Einstellung kann durch eine Veränderung des Widerstands erreicht werden, die beispielsweise durch eine Querschnittsreduzierung, eine Verwendung unterschiedlicher Materialien mit verschiedenen spezifischen Widerständen oder Verwendung eines Bypassleiters mit einem niedrigeren spezifischen Widerstand erreicht werden. Der Anteil des Bypassstroms zum Gesamtstrom, der durch einen dieser Leiter fließt, kann dabei so bemessen werden, dass idealerweise auftretende Gleichfeldkomponenten perfekt unterdrückt werden können. Hierzu kann eine Anpassung an einen vorgebbaren Strombereich angedacht werden, an dem sich die Veränderung des Widerstands orientiert. Die Widerstandsveränderung kann einstellbar sein, beispielsweise mittels konstruktiver Maßnahmen kann der Widerstand durch eine Erhöhung oder Verringerung des Querschnitts oder einer Erhöhung oder Verringerung eines Widerstands in den vom Bypassleiter umgangenen Abschnitt eingestellt werden, so dass der Messwertebereich ideal verstellt werden kann. So kann auch der Einsatz eines spannungsabhängigen Widerstands, d.h. eines Varistors angedacht werden. Die Widerstandsveränderung kann dabei nur in wenigen Prozenten liegen, da der Bypassleiter nur wenige Prozent des Stroms aufnimmt, der durch den Stromleiter fließt, oder auch einen hohen Widerstandsunterschied betragen.

In einer weiteren vorteilhaften Ausführungsform weisen die magnetoresistiven Gradientensensoren jeweils eine Feldkompensationseinrichtung auf, die für eine Messbereichskalibrierung einstellbar ist. Mithilfe einer Feldkompensationseinrichtung, die vorzugsweise auf einer Closed-Loop Regelung zur Elimination eines Gleichfeldes beruht, kann ein vorgebbares Grundmagnetfeld eingestellt werden, das somit den Arbeitspunkt des Gradientensensors bestimmt. Durch eine Messbereichskalibrierung kann die Feldkompensationseinrichtung ein einstellbares Magnetfeld erzeugen, so dass die Strommessvorrichtung auf verschieden große Stromessbereiche eingestellt werden kann.

Vorteilhafterweise hat sich gezeigt, dass der Bypassstrom weniger als 20 %, bevorzugt weniger als 10 % und insbesondere weniger als 5 % des Leiterstroms beträgt. Mit einer derart geringen Strommenge können die Bypassleiter einen relativ geringen Querschnitt aufweisen und es ist keine Hochstrombelastbarkeit für die Bypassleiter erforderlich, so dass Isolationsabstände und - Materialen entsprechend geringer dimensioniert werden können. Hierdurch lässt sich konstruktiv eine einfach und günstig zu realisierende Strommessvorrichtung bereitstellen.

ZEICHNUNGEN

Weitere Vorteile ergeben sich aus der vorliegenden Zeichnungsbeschreibung. In den Zeichnungen sind Ausführungsbeispiele der Erfindung dargestellt. Die Zeichnung, die Beschreibung und die Ansprüche enthalten zahlreiche Merkmale in Kombination. Der Fachmann wird die Merkmale zweckmäßigerweise auch einzeln betrachten und zu sinnvollen weiteren Kombinationen zusammenfassen.

Es zeigen:

**Fig. 1** schematisch in einer Draufsicht eine Konfiguration einer Dreiphasenstrommessvorrichtung des Stands der Technik,

**Fig. 2** ein typischer Stromverlauf eines Dreiphasennetzwerks,

| | |
|---|---|
| **Fig. 3** | Gradient und Gleichfeldkomponente, die sich zwischen Stromphasen L1-L2 bei einem Stromverlauf nach Fig. 2 einstellt, |
| **Fig. 4** | einen sensorsensitiven Gradientenbereich und ein sensorneutraler Bereich eines Gradientensensors in schematischer Form, |
| **Fig. 5** | eine erste Ausführungsform einer erfindungsgemäßen Strommessvorrichtung, |
| **Fig. 6** | ein Schnitt durch die in Fig. 5 dargestellte Strommessvorrichtung, |
| **Fig. 7** | eine weitere Ausführungsform einer erfindungsgemäßen Strommessvorrichtung, |
| **Fig. 8a, 8b** | Schnittdarstellungen verschiedener Varianten der in Fig. 7 dargestellten Strommessvorrichtung, |
| **Fig. 9** | ein weiteres Ausführungsbeispiel einer erfindungsgemäßen Strommessvorrichtung, |
| **Fig. 10** | ein weiteres Ausführungsbeispiel einer erfindungsgemäßen Strommessvorrichtung, |
| **Fig. 11** | ein Ausführungsbeispiel einer Vierphasen-Strommessvorrichtung gemäß der Erfindung, |
| **Fig. 12** | einen Querschnitt durch ein Ausführungsbeispiel einer Sechsphasenstrommessvorrichtung gemäß der Erfindung, |
| **Fig. 13** | eine Teildarstellung einer Ausführungsform, der in Fig. 12 dargestellten Sechsphasenstrommessvorrichtung, |
| **Fig. 14** | eine Teildarstellung einer Variante der in Fig. 12 dargestellten Sechsphasenstrommessvorrichtung. |

In den Figuren sind gleichartige Elemente mit gleichen Bezugszeichen beziffert.

Die Figuren zeigen lediglich Beispiele und sind nicht beschränkend zu verstehen.

In der Fig. 1 ist eine aus dem Stand der Technik bekannte Dreiphasenstrommessvorrichtung 100 dargestellt. Die Strommessvorrichtung 100 umfasst drei parallel geführte Stromleiter 12, die jeweils eine Stromphase L1, L2 und L3 des Dreiphasenstromnetzes führen. Zwischen dem Stromleiter 12, der den Phasenstrom L1 führt, und dem Stromleiter 12, der den Phasenstrom L2 führt, ist ein magnetoresistiver Gradientensensor 14, S1, eingeschaltet, der ein Gradientenmagnetfeld zwischen beiden Stromleitern 12 L1-L2 misst. Zwischen den beiden Stromleitern 12, die die Phasen L2 und L3 führen, ist ein weiterer Gradientensensor 14, S2, zur Messung des Phasengradienten L2-L3 zwischengeschaltet.

Durch die Bestimmung der beiden Feldgradienten mittels der Gradientsensoren 14, S1, S2 kann durch ein hinlänglich bekanntes Verfahren der Gesamtstrom in den drei Stromleitern 12 bestimmt werden, da die beiden Gradientenwerte jeweils eine Differenz der Phasenströme von $I_1$, $I_2$ und $I_3$ der Stromphasen L1, L2 und L3 proportional sind. Somit ergibt sich aus den Phasenströmen die beiden Gradientenwerte $U_{S1}$ und $U_{S2}$ der beiden Gradientensensoren S1, S2:

$$U_{S1} = K_1 \cdot (I_1 - I_2)$$

$$U_{S2} = K_2 \cdot (I_2 - I_3)$$

mit $K_1$, $K_2$ Proportionalitätsfaktoren, die die Beziehung der Gradientensensormesswerte zu der Stärke der Stromdifferenzen angibt, und unter Berücksichtigung der Kirchhoff'schen Regel:

$$\sum_{n=1}^{3} I_n = I_1 + I_2 + I_3 = 0$$

erhält man drei Gleichungen mit den drei Unbekannten $I_1$, $I_2$ und $I_3$, wobei man durch eine Summen- und eine Differenzbildung der Messwerte der Gradientensensoren:

$$U_{S1} - U_{S2} \; = \; K_1 \cdot (I_1 - I_2) - K_2 \cdot (I_2 - I_3)$$

und

$$U_{S1} + U_{S2} \; = \; K_1 \cdot (I_1 - I_2) + K_2 \cdot (I_2 - I_3)$$

mit der Randbedingung:

$$I_1 + I_3 = -I_2$$

und unter der Voraussetzung das $K_1$ gleich $K_2 = K$ ist, d. h. gleichartige Feldgradientensensoren eingesetzt werden, nun auf die Formel stößt

$$U_{S1} - U_{S2} \; = \; K \cdot (I_1 + I_3 - 2I_2) = K \cdot (-3I_2)$$

Durch entsprechend weitere Berechnungen erhält man jeweils jeden Leiterstrom $I_1$, $I_2$ und $I_3$ der drei Stromphasen L1, L2 und L3 auf einfachem Weg.

In einem Mehrphasensystem mit N>3 lässt sich das Gleichungssystem entsprechend mehrdimensional zu einem linearen und positiv definierten Gleichungssystem erweitern, so dass jeweils eine eindeutige Bestimmung der einzelnen Leiterströme durch Messung der Feldgradienten zwischen zwei benachbarten Strömen möglich ist.

Die eingesetzten Gradientensensoren 14, S1, S2 weisen in einem vordefinierbaren Magnetfeldbereich einen linearen Verlauf auf, d.h., eine Größe des Sensormesswertes entspricht linear einer Differenz der Ströme zwischen den benachbarten Stromleitern. Fließt allerdings ein hoher Gleichanteil durch beide Stromleiter, so wird der Messpunkt des Gradientensensors in einen nichtlinearen Bereich geschoben, in dem entweder keine Proportionalität herrscht, oder überhaupt kein Gradient mehr gemessen werden kann, da eine Sättigung des magnetoresistiven Verhaltens des Gradientensensors erreicht wird. Somit war es mit der in Fig. 1 dargestellten, aus dem Stand der Technik bekannten Strommessvorrichtung nicht möglich, Hochstromanwendungen exakt messen zu können.

In Fig. 2 ist ein typischer sinusförmiger Verlauf eines Dreiphasensystems mit den drei Strömen $I_1$, $I_2$ und $I_3$ der drei Stromphasen L1, L2 und L3 dargestellt. Jeder Strom ist gegenüber dem benachbarten Strom um jeweils 120° versetzt.

In Fig. 3 ist bezüglich des Sensors S1 14 aus Fig. 1 sowohl das Gradientenfeld, das sich zwischen den Stromphasen L1 und L2 ausbildet, als auch eine Gleichfeldkomponente, die jeweils dadurch entsteht, dass Ströme in gleicher Richtung geführt werden, veranschaulicht. Es ist deutlich erkennbar, dass in Bezug auf die Stromphasen L1 und L2 jeweils ein Maximum der Gleichkomponente bei 30° und bei 210° erreicht wird. In diesen Bereichen entsteht eine hohes magnetisches Gleichfeld, so dass Gradienten zwischen diesen beiden Stromleitern durch den Sensor S1 14 kaum mehr exakt gemessen werden können. Dies ergibt Verzerrungen und somit Ungenauigkeiten, insbesondere bei Strömen, die mehrere hundert Ampere im Peak erreichen können, wobei insbesondere bei einer betrachteten Anordnung mit 600 A Peak mit der in der Fig. 1 dargestellten Ausführungsform keine verwertbaren Messergebnisse erzielt werden können.

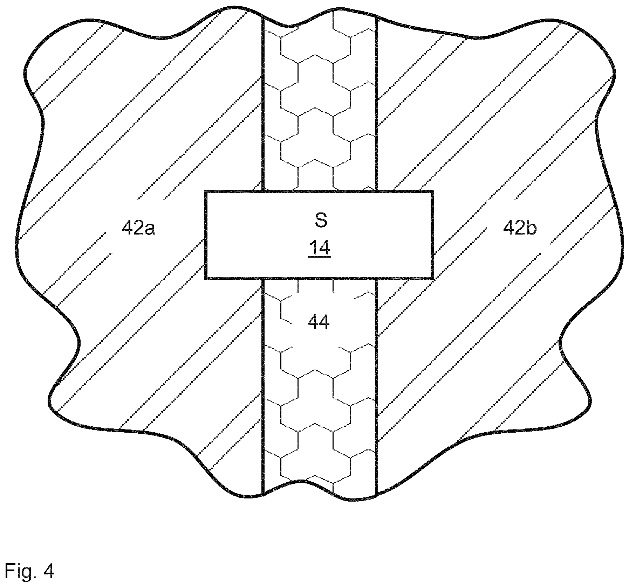

Fig. 4 zeigt schematisch die Messbereiche eines Gradientensensors S 14, wie er der Erfindung zugrunde liegt. Der Messsensor 14 definiert einen räumlichen Messbereich, der zwei Gradientenbereiche 42a und 42 b umfasst. Magnetfelder, die den Bereich 42a zu 42b überbrücken, werden durch den Sensor S 14 erfasst, und deren Differenz als Gradientenwert durch den Sensor S ausgegeben. Dazwischen befindet sich ein sogenannter Neutralbereich 44, der symmetrisch zur räumlichen Ausdehnung des Sensors S liegt, und in dessen Bereich Magnetfeldkomponenten keine nennenswerte Auswirkung auf den Sensorwert haben. Dies ist ein sozusagen sensorwertneutraler Bereich, in denen symmetrisch ausgebildete Magnetfelder durchgeführt werden können, die keinen Einfluss auf den Sensorwert haben. Herrschen in den Gradientenbereichen 42a und 42b ein hohes Gleichfeld vor, so können geringfügige Gradientenunterschiede durch den Sensor S kaum mehr erfasst werden. Zur Kompensation kann im Neutralbereich 44 ein gegenläufiges Magnetfeld geführt werden, das ausgelegt ist, die hohen Gleichanteile, die sowohl im Gradientenbereich 42a als auch 42b herrschen, zu kompensieren. Hierdurch wird es ermöglicht, im Gradientensensor S wieder einen linearen Arbeitsbereich einzustellen, so dass eine exakte Messung der Gradientenunterschiede zwischen den Gradientenbereichen 42a und 42 b erfassbar wird.

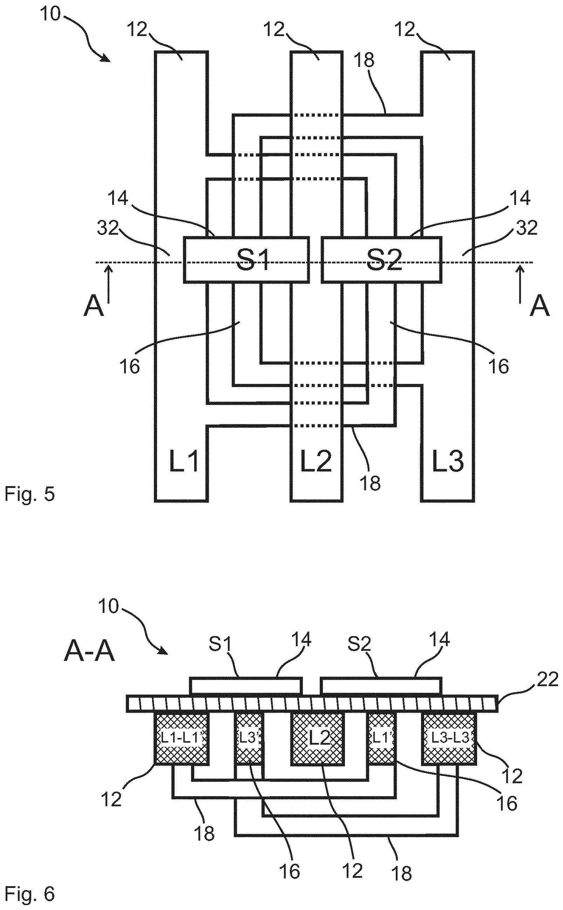

In Fig. 5 ist ein erstes Ausführungsbeispiel 10 einer erfindungsgemäßen Strommessvorrichtung für eine Dreiphasenanwendung dargestellt. Die drei Stromphasen L1, L2 und L3 werden in drei parallel geführten Stromleitern 12 geführt. Zwischen jeweils zwei benachbarten Stromleitern 12 ist ein Gradientensensor 14, S1, S2 angeordnet. Ein Stromleiterabschnitt 32, in dem der Gradientensensor 14 angeordnet ist, wird von einem Bypassleiter 16 umgangen. Der Bypassleiter 16 umfasst zwei Zuführungsleiter 18, die rechtwinklig vom Stromleiter 12 wegführen und den jeweils benachbarten Stromleiter 12 unter- oder überqueren, und in einen zum Stromleiterverlauf 12 parallelen Bypassleiterabschnitt 16 überführen, der durch den Neutralbereich 44 des Gradientensensors 14 des jeweils nicht unmittelbar benachbarten Stromleiterpaars 12 angeordnet ist, führt. Somit wird ein Stromanteil der Stromphase L1 durch mittig im Neutralbereich 44 unter dem Gradientensensor S2 14 geführt, der den Feldgradienten zwischen den Stromleitern L2 und L3 beeinflusst. Umgekehrt wird ein Bypassstrom der Phase L3 durch den Neutralbereich 44 des Gradientensensors S1 14 geführt, der den Feldgradienten der beiden Stromphasen L1 und L2 beeinflusst. Dadurch, dass die Bypassleiter 16 jeweils im Neutralbereich 44 des Gradientensensors 14 verlaufen, haben die darin geführten Ströme keinen Einfluss auf den Sensorwert. Ein maximales Gleichfeld benachbarter Stromleiter 12 tritt dann auf, wie auf den benachbarten Stromleitern 12 der Strom jeweils die gleiche Stärke und die gleiche Richtung beträgt. Dies gilt beispielsweise in den Stromphasen L1 und L2 in den Phasenwinkeln 30° und 210°, wie in Fig. 3 dargestellt ist. Zu diesen Zeitpunkten ist auf der dritten Schiene L3 12 der Strom maximal in entgegengesetzter Richtung gerichtet. Über den Bypassleiter 16 unterhalb des Gradientensensors 14 wird somit ein Teil des Stroms der dritten Phase L3 geführt und erzeugt ein Gleichfeld, das in vergleichbarer Höhe, aber in entgegengesetzter Richtung gerichtet ist. Bei der symmetrischen Anordnung des Bypassleiters unter dem Gradientensensor 14 wird durch den Bypassleiter 16 kein Gradientenfeld erzeugt, jedoch der lineare Arbeitspunkt des Gradientensensors 14 eingestellt.

In Fig. 5 ist eine Schnittebene A-A eingezeichnet, die in der Fig. 6 als Schnittbild gezeigt ist. Deutlich erkennbar sind die Gradientensensoren 14 auf einer Isolatorschicht 22, beispielsweise einer gedruckten Schaltungsplatine (PCB) angeordnet. Unterhalb der Isolatorschicht verlaufen die Stromleiter 12, die jeweils ein Stromphasenanteil L1-L1', L2 und L3-L3' im Bereich der orthogonalen Achse A-A führen. Die übrigen Stromphasenanteile L1' und L3' werden von Bypassleitern 16, die symmetrisch zu dem jeweiligen Gradientensensor 14 angeordnet sind, geführt. Diese erzeugen ein Kompensationsfeld, um bei hohem Gleichanteil in den benachbarten Stromleitern ein Gegenmagnetfeld herzustellen, und den linearen Arbeitsbereich der Gradientensensoren 14 aufrechtzuerhalten. Die Zuführleiter 18 sind in zwei unterhalb der Isolatorschicht 22 horizontal benachbarten Lagen geführt, und umgehen jeweils den mittleren Stromleiter 12.

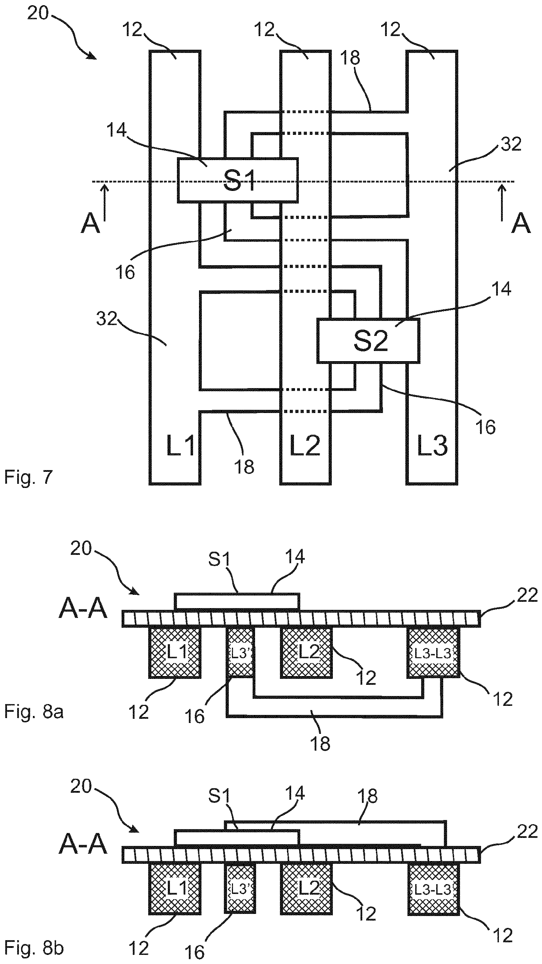

In Fig. 7 ist ein weiteres Ausführungsbeispiel 20 einer Dreiphasen-Strommessvorrichtung dargestellt. Im Unterschied zur in Fig. 5 dargestellten Ausführungsform 10 sind die beiden Gradientensensoren 14 nicht entlang einer orthogonalen Achse zur Führung der Stromleiter 12 angeordnet, sondern in Längsrichtung zu den Stromleitern 12 versetzt angeordnet. Dadurch ergibt sich die Möglichkeit, dass die Bypassleiter 16 und die Zuführleiter 18 der beiden Bypasse sich nicht überschneiden, sondern getrennt voneinander geführt werden können. Die Strommessvorrichtung 20 ist somit in longitudinaler Richtung der Stromleiter 12 vergrößert, allerdings ist der konstruktive Aufwand verringert, da die Zuführungsleiter 18 keine weiteren Bypassleiter 16 kreuzen müssen, und somit ein mehrlagiger Aufbau vermieden werden kann. Hierdurch kann ein vereinfachter Aufbau erreicht werden. Die jeweiligen von den Bypassleitern 16 umgangenen Bereiche 32 der Stromleiter sind somit longitudinal versetzt zueinander angeordnet.

In der Fig. 8a ist ein Schnittbild durch die orthogonale Schnittlinie A-A, die in Fig. 7 dargestellt ist, gezeigt. Der Bypassleiter 16 wird von einem Zuführleiter 18 gespeist, der einen Teil L3' des Stromleiters L3 führt, so dass in diesem nur ein Strom L3 - L3' führt.

In der Figur 8b ist alternativ dargestellt, dass der Zuführleiter 18 durch eine Durchkontaktierung durch die Isolatorschicht 22 auf der Oberseite der Isolatorschicht 22 geführt werden kann, so dass eine nur zweischichtige Isolatorschicht 22 eingesetzt werden kann, so dass ein mehrlagiger Aufbau der Strommessvorrichtung vermieden wird. Eine derartige Variante kann ebenfalls in der Fig. 6 angedacht sein, in denen einer der beiden Zuführleiter 18 oberhalb des Stromleiters 22 geführt wird. Hierdurch kann mit einem relativ kostengünstigen Herstellverfahren eine zweiseitig beschichtete bzw. zweiseitig mit Strom führende Komponenten belegte Platine zur Ausbildung der Strommessvorrichtung eingesetzt werden.

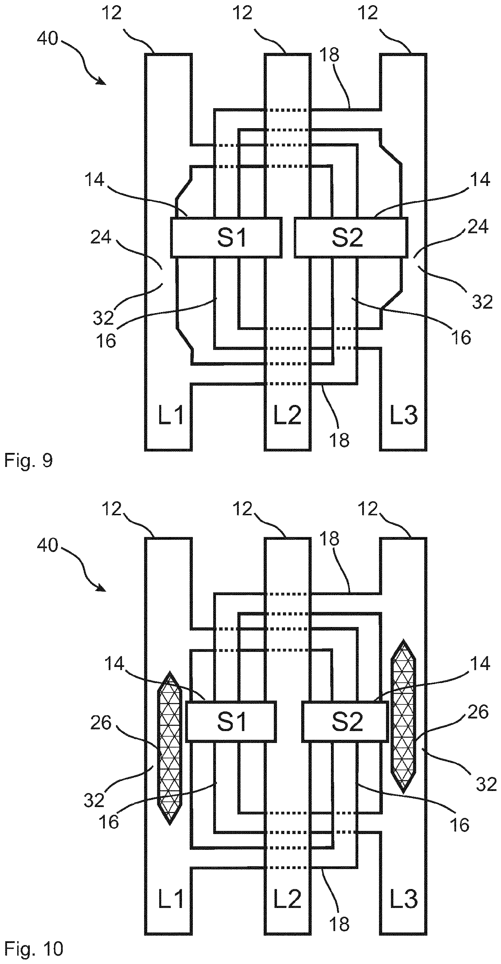

In der Fig. 9 ist ein weiteres Ausführungsbeispiel 40 einer Dreiphasen-Strommessvorrichtung dargestellt. Diese orientiert sich in ihrem strukturellen Aufbau an der in Fig. 5 dargestellten Ausführungsform 10. Im Unterschied hierzu ist im Bereich 32 jedes Stromleiters 12, der von einem Bypassleiter 16 umgangen wird, eine Querschnittsverengung vorgenommen, so dass ein querschnittsreduzierter Stromleiterbereich 24 vorgesehen ist. Durch die Reduzierung des Stromleiterbereichs wird der effektive Widerstand in diesem Bereich geringfügig erhöht, so dass die Menge oder der Stromanteil, der durch den Bypassleiter 16 geführt wird, hierdurch eingestellt werden kann. In der Regel genügt es, 20 % oder weniger, bevorzugt 10 %, insbesondere 5 % des im Stromleiter 12 geführten Stroms durch den Bypassleiter zu führen.

Alternativ hierzu zeigt Fig. 10 ein weiteres Ausführungsbeispiel 40 der Strommessvorrichtung, bei der in dem vom Bypassleiter umgangenen Bereich 32 ein Widerstandsbereich 26, beispielsweise der Einsatz eines Materials mit einem geringfügig höheren spezifischen Widerstand, vorgesehen ist. Hierdurch werden Widerstandsbereiche, in denen beispielsweise Aluminium statt Kupfer eingesetzt wird, oder in denen eine Mischlegierung verwendet wird, die einen geringfügig höheren Widerstand aufweist, gebildet, so dass ein definierbarer Stromanteil durch die Bypassleiter 16 geführt werden kann. Alternativ ist denkbar, die Bypassleiter 16 aus einem Material auszubilden, das eine höhere Leitfähigkeit aufweist, so dass sich eine definierbare Aufteilung des Stroms durch den Stromleiter 12 ergibt, und im Bypassleiter ein Stromfluss in einem prozentualen Verhältnis zum Gesamtstrom, der durch den Stromleiter 12 geführt wird, eingestellt werden kann.

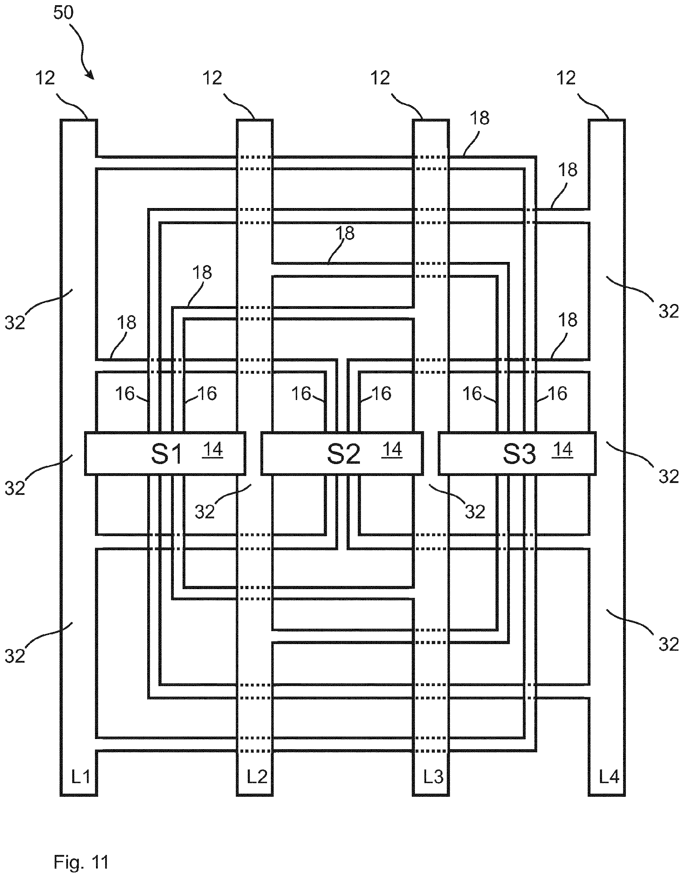

In der Fig. 11 ist eine Vierphasen-Strommessvorrichtung 50 als weiteres Ausführungsbeispiel der Erfindung dargestellt. Hierzu sind vier benachbarte Stromleiter 12 vorgesehen. Jeder Stromleiter 12 führt eine Stromphase L1, L2, L3 und L4. Zwischen zwei benachbarten Stromleitern 12 ist jeweils ein Gradientensensor 14 S1, S2 und S3 vorgesehen. Jeder Gradientensensor 14 misst ein Gradientenfeld zwischen zwei benachbarten Stromleitern 12. Zur Kompensation der Gleichfeldanteile werden Bypassleitungen 16 der jeweils nicht benachbarten Stromleiter 12 benötigt, die nach dem dargestellten Schema verlegt werden können. In diesem Beispiel sind die Gradientensensoren 14 auf einer orthogonalen Achse zum Verlauf der Stromleiter 12 angeordnet. Alternativ ist auch denkbar, die Gradientensensoren 14 versetzt zueinander anzuordnen, so dass es keine Mehrfachüberlappungen der Bypassleiter 16 gibt, und somit konstruktiv eine vereinfachte Realisierung der Stromleiterführung ermöglicht wird. Durch den Gradientensensor 14 S1 werden somit Bypassleiter 16 der Stromphasen L3 und L4 geführt. Durch den Gradientsensor 14 S2 werden Bypassleiter 16 der Stromphasen L1 und L4 geführt. Durch den Gradientsensor 14 S3 werden Bypassleiter 16 der Stromphasen L1 und L2 geführt. Ein Vierphasensystem kann beispielsweise bei Spezialanwendungen eingesetzt werden und lässt sich beliebig skalieren zu einem Fünf-, Sechs- oder Mehrfachphasensystem.

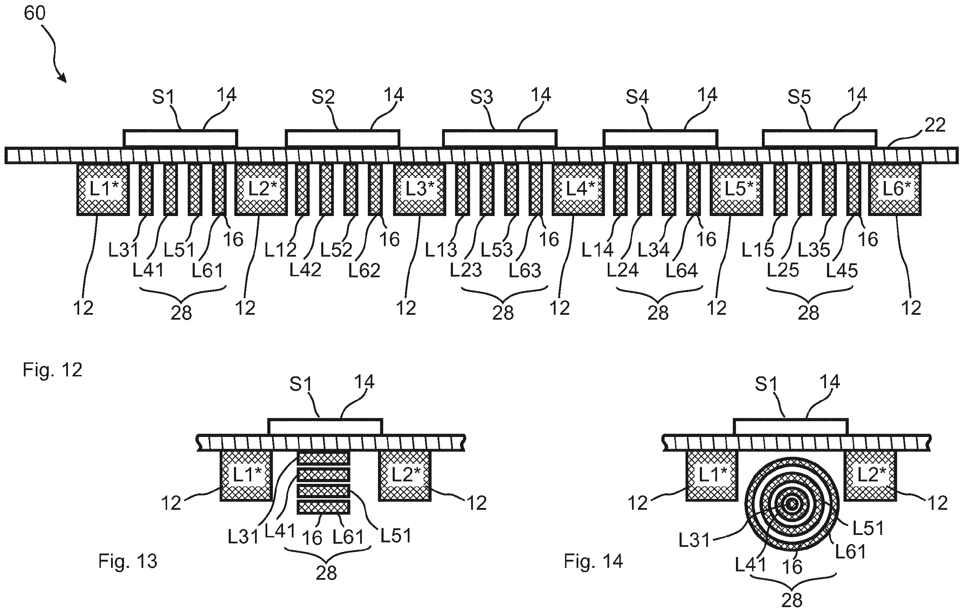

In Fig. 12 ist ein weiteres Ausführungsbeispiel 60 eines Sechsphasensystem im Querschnitt dargestellt, bei dem sechs Stromphasen L1 bis L6 unterhalb einer Isolatorschicht 22 geführt werden, und fünf Gradientensensoren 14, S1 bis S5 jeweils zwischen den Stromleitern 12 angeordnet sind. Im Neutralbereich 44 jedes Gradientensensors 14 sind somit vier Bypassleiter 16 von den übrigen, nicht unmittelbar benachbarten Stromleitern 12 angeordnet. Diese werden in der Nomenklatur beispielsweise bezüglich des Gradientensensors S1 mit L31, L41, L51 und L61 bezeichnet und führen Bypassströme der Leiter L3, L4, L5 und L6. Somit ergeben sich jeweils Gruppen 28 von Bypassleitern, die im Neutralbereich des Gradientensensors 14 geführt werden.

Die Fig. 13 und 14 zeigen verschiedene Ausführungsformen, wie die Bypassleiter 16 im Neutralbereich 44 der Gradientensensoren 14 in der Ausführungsform 60 der Fig. 12 geführt werden können. Während in Fig. 12 die Bypassleiter 16 in der Messebene horizontal benachbart zueinander geführt sind, können sie wie in Fig. 13 dargestellt, in der neutralen Messebene vertikal aufeinandergestapelt werden, oder auch, wie in Fig. 14 dargestellt, konzentrisch zueinander geführt in der Art eines mehrschichtigen Koaxialkabels geführt werden. Damit lässt sich eine räumliche Konzentration des Gleichfelds im Neutralbereich 44 jedes Gradientensensors 14 erreichen, so dass auch bei Mehrphasenanwendungen bei hohen Strömen ein linearer Messbereich der Gradientensensoren 14 eingestellt und somit exakt gemessen werden kann.

In der Erfindung wird insbesondere für ein Dreiphasensystem, aber auch für ein Mehrphasensystem mit N>3 vorgeschlagen, dass der Strom die jeweils nicht von einem Gradientensensor erfasste Phase aufgrund seiner Gegenphasigkeit zur Kompensation des zwischen dem Strom, der bei benachbarten Stromleitern ein Gleichfeld erzeugt, eingesetzt wird. Über einen Bypassleiter wird ein kleiner Teil des Stroms der übrigen Phase abgegriffen und symmetrisch mittig direkt unter den Gradientensensor zwischen den Phasen der benachbarten Stromleiter geführt. Die Feldgradienten können orthogonal auf derselben Achse zur Leiterschiene angeordnet sein, so dass in Längsrichtung ein geringer Platzbedarf der Strommessvorrichtung benötigt wird. Bei einem Dreileitersystem wird der Strom in der mittleren Stromschiene L2 nicht reduziert, und die beiden äußeren Stromschienen führen jeweils einen reduzierten Strom in vom Bypassleiter umgangenen Bereich, der als Kompensationsfeld durch die Bypassleiter geführt wird. Bei der Berechnung des Gesamtstroms muss aufgrund des reduzierten Gradientenfeldes bei der Lösung des vorgenannten Gleichungssystems eine Berücksichtigung dieser Einzelströme mit entsprechenden Faktoren vorgenommen werden.

In einer alternativen Variante können die Gradientensensoren in Längsrichtung zueinander versetzt angeordnet werden, so dass sich die Bypassleitungen nicht überkreuzen. Hierdurch wird in longitudinaler Richtung der Leiterschienen ein erhöhter Platzbedarf benötigt, jedoch kann ein kompakteres Design hinsichtlich der Führung der Bypassleiter erreicht werden, und der konstruktive Aufwand bei der hardwaretechnischen Realisierung kann minimiert werden. Auch braucht in diesen Fällen keine Berücksichtigung des reduzierten Gradientenfeldes pro Sensor vorgenommen werden, da zwischen den benachbarten Stromleitungen jeweils der volle Strom fließt, da hier kein Bypassstrom abgezweigt wird. Somit ergibt sich eine reduzierte Rechenvorschrift, die sich an den bisherigen Rechenvorschriften orientiert.

Durch die Erfindung ist es möglich, eine Drei- oder auch eine Mehrphasen-strommessvorrichtung gezielt für Hochstromanwendungen mit mehreren hundert Ampere Peak pro Stromleiter einzusetzen, und weiterhin einen linearen Aussteuerbereich der Gradientensensoren bereitzustellen. Dadurch lässt sich die vorgeschlagene Strommessvorrichtung universell für beliebig hohe Strombelastungen einsetzen, so dass gegenüber dem Stand der Technik große Vorteile erreicht werden.

**Bezugszeichenliste**

| | |
|---|---|
| 10 | Erstes Ausführungsbeispiel einer Strommessvorrichtung |
| 12 | Stromleiter |
| 14 | Magnetoresistiver Gradientensensor |
| 16 | Bypassleiter |
| 18 | Zuführungsleiter der Bypassleiter |
| 20 | Zweites Ausführungsbeispiel einer Strommessvorrichtung |
| 22 | Isolatorschicht |
| 24 | Querschnittsreduzierter Stromleiterbereich |
| 26 | Widerstandsbereich / Isolationsbereich |
| 28 | Gruppe von Bypassleiter |
| 30 | Drittes Ausführungsbeispiel einer Strommessvorrichtung |
| 32 | Von dem Bypassleiter umgangener Stromleiterabschnitt |
| 40 | Viertes Ausführungsbeispiel einer Strommessvorrichtung |
| 42 | Gradientenbereich |
| 44 | Neutralbereich |
| 50 | Fünftes Ausführungsbeispiel einer Strommessvorrichtung |
| 60 | Sechstes Ausführungsbeispiel einer Strommessvorrichtung |
| 100 | Strommessvorrichtung des Stands der Technik |

**Patentansprüche**

1. Mehrphasen-Strommessvorrichtung (10, 20, 30, 40, 50, 60) zur Messung von Strömen eines Mehrleiterstromsystems mit $N$ Stromphasen, die entlang $N$ Stromleitern (12) geführt werden, und $N>2$, umfassend $N$-1 magnetoresistive Gradientensensoren (14) zur Bestimmung einer magnetischen Feldstärkedifferenz in einer Messebene zwischen Leiterströmen benachbarter Stromleiter (12), **gekennzeichnet dadurch, dass** bezüglich jedes magnetoresistiven Gradientensensors (14) zumindest ein Bypassleiter (16) zumindest eines der weiteren, nicht unmittelbar benachbarten Stromleiter (12) angeordnet ist, wobei der zumindest ein Bypassleiter dazu eingerichtet ist, eine Gleichfeldkomponente der Leiterströme der beiden benachbarten Stromleiter (12) zu kompensieren.

2. Mehrphasen-Strommessvorrichtung (10, 20, 30, 40, 50, 60) nach Anspruch 1, **dadurch gekennzeichnet, dass** der zumindest eine Bypassleiter (16) oder eine Gruppe (28) von Bypassleitern (16) symmetrisch bezüglich der Messebene des magnetoresistiven Gradientensensors (14) angeordnet ist, so dass das durch den zumindest einen Bypassleiter (16) oder der Gruppe (28) von Bypassleitern (16) erzeugte Bypassmagnetfeld kein Gradientenmesssignal des magnetoresistiven Gradientensensors (14) bewirkt.

3. Mehrphasen-Strommessvorrichtung (10, 20, 30, 40, 50, 60) nach Anspruch 1 oder 2, **dadurch gekennzeichnet, dass** der durch einen Bypassleiter (16) eines Stromleiters (12) führbare Stromanteil eines Leiterstroms des Stromleiters (12), insbesondere durch eine Querschnittsreduzierung (24), einen Isolationsbereich und/oder einen Widerstandsbereich (26) des von dem Bypassleiter (16) umgangenen Abschnitts (32) des Stromleiters (12), einstellbar ist.

4. Mehrphasen-Strommessvorrichtung (10, 20, 30, 40, 50, 60) nach einem der vorgenannten Ansprüche, **dadurch gekennzeichnet, dass** alle magnetoresistiven Gradientensensoren (14) entlang einer orthogonalen Achse zur Längserstreckung der Stromleiter (12) angeordnet sind.

5. Mehrphasen-Strommessvorrichtung (10, 20, 30, 40, 50, 60) nach einem der vorgenannten Ansprüche 1 bis 3, **dadurch gekennzeichnet, dass** die magnetoresistiven Gradientensensoren (14) zur Längserstreckung der Stromleiter (12) versetzt angeordnet sind.

6. Mehrphasen-Strommessvorrichtung (10, 20, 30, 40, 50, 60) nach einem der vorgenannten Ansprüche, **dadurch gekennzeichnet, dass** die magnetoresistiven Gradientensensoren (14) oberhalb einer Isolatorschicht (22) und die Stromleiter (12) und die Bypassleiter (16) unterhalb der Isolatorschicht (22) angeordnet sind, wobei bevorzugt zumindest ein Zuführungsleiter (18) der Bypassleiter (16) oberhalb der Isolatorschicht (22) geführt ist.

7. Mehrphasen-Strommessvorrichtung (10, 20, 30, 40, 50, 60) nach einem der vorgenannten Ansprüche, **dadurch gekennzeichnet, dass** die Zuführungsleiter (18) der Bypassleiter (16) in unterschiedlichen Leitungsebenen unterhalb und/oder oberhalb der Messebene der magnetoresistiven Gradientensensoren (14) und der Stromleiter (12) verlaufen, und dass die Bypassleiter (16) im Wesentlichen in der Ebene der Stromleiter (12) und parallel zu den Stromleitern (12) verlaufen.

8. Mehrphasen-Strommessvorrichtung (10, 20, 30, 40, 50, 60) nach einem der vorgenannten Ansprüche, **dadurch gekennzeichnet, dass** mehrere Bypassleiter (16) horizontal oder vertikal benachbart bezüglich der Messebene oder konzentrisch in der Messebene des magnetoresistiven Gradientensensors (14) angeordnet sind.

9. Mehrphasen-Strommessvorrichtung (10, 20, 30, 40, 50, 60) nach einem der vorgenannten Ansprüche, **dadurch gekennzeichnet, dass** der magnetoresistive Gradientensensor (14) eine, bevorzugt einstellbare, Feldkompensationseinrichtung umfasst.

10. Mehrphasen-Strommessvorrichtung (10, 20, 30, 40, 50, 60) nach einem der vorgenannten Ansprüche, **dadurch gekennzeichnet, dass** die Stromleiter (12) und / oder die Bypassleiter (16) einzeln oder gemeinsam in einer Ferritstruktur umfasst sind, um eine Magnetflussrichtung vorzugeben.

11. Mehrphasen-Strommessvorrichtung (10, 20, 30, 40, 50, 60) nach einem der vorgenannten Ansprüche, **dadurch gekennzeichnet, dass** drei Stromleiter (12) und zwei magnetoresistive Gradientensensoren (14) umfasst sind.

12. Verfahren zur Mehrphasen-Strommessung, bevorzugt unter Verwendung einer Mehrphasen-Strommessvorrichtung (10, 20, 30, 40, 50, 60) mit $N$ Stromphasen nach einem der vorangegangenen Ansprüche, wobei $N$-1 magnetoresistive Gradientensensoren (14) zur Messung von $N$ Leiterströmen der $N$ Stromphasen mit $N>2$ eingesetzt werden, und zur Bestimmung einer magnetischen Feldstärkedifferenz in einer Messebene zwischen Leiterströmen benachbarter Stromleiter (12) jeweils ein magnetoresistiver Gradientensensor (14) mit einer Messebene zwischen zwei benachbarten Stromleitern (12) angeordnet ist, **gekennzeichnet dadurch, dass** zur Unterdrückung einer Gleichfeldkomponente der Leiterströme der beiden benachbarten Stromleiter (12) ein Bypassstrom zumindest eines weiteren, nicht unmittelbar benachbarten Stromleiters (12), bevorzugt Bypassströme aller weiteren, nicht unmittelbar benachbarten Stromleiter (12), symmetrisch zur Messebene des magnetoresistiven Gradientensensors (14) geführt wird.

13. Verfahren nach Anspruch 12, **dadurch gekennzeichnet, dass** die Größe des oder der Bypassströme durch eine Veränderung des Widerstands eines von dem Bypassleiter (16) umgangenen Abschnitts (32) des Stromleiters (12) eingestellt wird.

14. Verfahren nach Anspruch 12 oder 13, **dadurch gekennzeichnet, dass** eine Feldkompensationseinrichtung der magnetoresistiven Gradientensensoren (14) zur Messbereichskalibrierung einstellbar ist.

15. Verfahren nach einem der Verfahrensansprüche 12 bis 14, **dadurch gekennzeichnet, dass** der Bypassstrom weniger als 20%, bevorzugt weniger als 10% und insbesondere weniger als 5% des Leiterstroms beträgt.

**Claims**

1. A multiphase current measuring apparatus (10, 20, 30, 40, 50, 60) for measuring currents of a multiconductor current system with $N$ current phases which are carried along $N$ current conductors (12) where $N>2$, comprising $N$-1 magnetoresistive gradient sensors (14) for determining a magnetic field strength difference in a measurement plane between conductor currents of adjacent current conductors (12), **characterised in that** at least one bypass conductor (16) of at least one of the further, non-immediately adjacent current conductors (12) is arranged with respect to each magnetoresistive gradient sensor (14), wherein the at least one bypass conductor is designed to compensate a DC field component of the conductor currents of the two adjacent current conductors (12).

2. A multiphase current measuring apparatus (10, 20, 30, 40, 50, 60) according to claim 1, **characterised in that** the at least one bypass conductor (16) or a group (28) of bypass conductors (16) is arranged symmetrically with regard to the measurement plane of the magnetoresistive gradient sensor (14), such that a bypass magnetic field generated by the at least one bypass conductor (16) or group (28) of bypass conductors (16) does not bring about a gradient measurement signal of the magnetoresistive gradient sensor (14).

3. A multiphase current measuring apparatus (10, 20, 30, 40, 50, 60) according to claim 1 or 2, **characterised in that** the current component of a conductor current of the current conductor (12) passable through a bypass conductor (16) of a current conductor (12) is adjustable, in particular by a cross-sectional reduction (24), an insulation region and/or a resistance region (26) of the portion (32) of the current conductor (12) bypassed by the bypass conductor (16).

4. A multiphase current measuring apparatus (10, 20, 30, 40, 50, 60) according to one of the above-stated claims, **characterised in that** all the magnetoresistive gradient sensors (14) are arranged along an axis orthogonal to the longitudinal extent of the current conductor (12).

5. A multiphase current measuring apparatus (10, 20, 30, 40, 50, 60) according to one of above-stated claims 1 to 3, **characterised in that** the magnetoresistive gradient sensors (14) are arranged offset relative to the longitudinal extent of the current conductor (12).

6. A multiphase current measuring apparatus (10, 20, 30, 40, 50, 60) according to one of the above-stated claims, **characterised in that** the magnetoresistive gradient sensors (14) are arranged above an insulator layer (22) and the current conductors (12) and the bypass conductors (16) below the insulator layer (22), wherein at least one feed conductor (18) of the bypass conductors (16) is preferably guided above the insulator layer (22).

7. A multiphase current measuring apparatus (10, 20, 30, 40, 50, 60) according to one of the above-stated claims, **characterised in that** the feed conductors (18) of the bypass conductors (16) extend in different conduction planes below and/or above the measurement plane of the magnetoresistive gradient sensors (14) and current conductors (12), and **in that** the bypass conductors (16) substantially extend in the plane of the current conductors (12) and parallel to the current conductors (12).

8. A multiphase current measuring apparatus (10, 20, 30, 40, 50, 60) according to one of the above-stated claims, **characterised in that** a plurality of bypass conductors (16) are arranged horizontally or vertically adjacent with regard to the measurement plane or concentrically in the measurement plane of the magnetoresistive gradient sensor (14).

9. A multiphase current measuring apparatus (10, 20, 30, 40, 50, 60) according to one of the above-stated claims, **characterised in that** the magnetoresistive gradient sensor (14) comprises a, preferably adjustable, field compensating device.

10. A multiphase current measuring apparatus (10, 20, 30, 40, 50, 60) according to one of the above-stated claims, **characterised in that** the current conductors (12) and/or the bypass conductors (16) are individually or jointly comprised in a ferrite structure in order to predetermine a magnetic flux direction.

11. A multiphase current measuring apparatus (10, 20, 30, 40, 50, 60) according to one of the above-stated claims, **characterised in that** three current conductors (12) and two magnetoresistive gradient sensors (14) are comprised.

12. A method for multiphase current measurement, preferably using a multiphase current measuring apparatus (10, 20, 30, 40, 50, 60) with $N$ current phases according to one of the preceding claims, $N$-1 magnetoresistive gradient sensors (14) being used for measuring $N$ conductor currents of the $N$ current phases where $N>2$, and in each case one magnetoresistive gradient sensor (14) with a measurement plane being arranged between two adjacent current conductors (12) for determining a magnetic field strength difference in a measurement plane between conductor currents of adjacent current conductors (12), **characterised in that** a DC field component of the conductor currents of the two adjacent current conductors (12) is suppressed by passing a bypass current of least one further, non-immediately adjacent current conductor (12), preferably bypass currents of all the further, non-immediately adjacent current conductors (12), symmetrically to the measurement plane of the magnetoresistive gradient sensor (14).

13. A method according to claim 12, **characterised in that** the magnitude of the bypass current(s) is adjusted by modifying the resistance of a portion (32) of the current conductor (12) bypassed by the bypass conductor (16).

14. A method according to claim 12 or 13, **characterised in that** a field compensating device of the magnetoresistive gradient sensors (14) is adjustable for measurement range calibration.

15. A method according to one of method claims 12 to 14, **characterised in that** the bypass current amounts to less than 20%, preferably less than 10% and in particular less than 5% of the conductor current.

**Revendications**

1. Dispositif de mesure de courant polyphasé (10, 20, 30, 40, 50, 60) destiné à mesurer des courants d'un système électrique multiconducteur avec *N* phases de courant conduites le long de *N* conducteurs électriques (12), et *N*>2, comprenant *N*-1 capteurs de gradient magnétorésistifs (14) pour déterminer une différence d'intensité de champ magnétique dans un plan de mesure situé entre les courants des conducteurs électriques (12) voisins, **caractérisé en ce que** relativement à chaque capteur de gradient magnétorésistif (14) est disposé au moins un conducteur de dérivation (16) d'au moins un des autres conducteurs électriques (12) non directement voisins, sachant que ledit au moins un conducteur de dérivation est configuré de sorte à compenser une composante de champ continu des courants des deux conducteurs électriques (12) voisins.

2. Dispositif de mesure de courant polyphasé (10, 20, 30, 40, 50, 60) selon la revendication 1, **caractérisé en ce que** ledit au moins un conducteur de dérivation (16) ou un groupe (28) de conducteurs de dérivation (16) est disposé symétriquement relativement au plan de mesure du capteur de gradient magnétorésistif (14) si bien que le champ magnétique de dérivation généré par ledit au moins un conducteur de dérivation (16) ou le groupe (28) de conducteurs de dérivation (16) ne provoque aucun signal de mesure de gradient du capteur de gradient magnétorésistif (14).

3. Dispositif de mesure de courant polyphasé (10, 20, 30, 40, 50, 60) selon la revendication 1 ou 2, **caractérisé en ce que** la portion d'un courant du conducteur électrique (12) conduisible à travers un conducteur de dérivation (16) d'un conducteur électrique (12) est réglable notamment par une réduction de section (24), une partie isolante et/ou une partie résistive (26) de la section (32) du conducteur électrique (12), contournée par le conducteur de dérivation (16).

4. Dispositif de mesure de courant polyphasé (10, 20, 30, 40, 50, 60) selon une des revendications précédentes, **caractérisé en ce que** tous les capteurs de gradient magnétorésistifs (14) sont disposés le long d'un axe orthogonal par rapport à l'extension longitudinale des conducteurs électriques (12).

5. Dispositif de mesure de courant polyphasé (10, 20, 30, 40, 50, 60) selon une des revendications précédentes 1 à 3, **caractérisé en ce que** les capteurs de gradient magnétorésistifs (14) sont disposés décalés par rapport à l'extension longitudinale des conducteurs électriques (12).

6. Dispositif de mesure de courant polyphasé (10, 20, 30, 40, 50, 60) selon une des revendications précédentes, **caractérisé en ce que** les capteurs de gradient magnétorésistifs (14) sont disposés au-dessus d'une couche isolante (22) et que les conducteurs électriques (12) et les conducteurs de dérivation (16) sont disposés en dessous de la couche isolante (22), sachant que de préférence, au moins un conducteur d'alimentation (18) des conducteurs de dérivation (16) est posé au dessus de la couche isolante (22).

7. Dispositif de mesure de courant polyphasé (10, 20, 30, 40, 50, 60) selon une des revendications précédentes, **caractérisé en ce que** les conducteurs d'alimentation (18) des conducteurs de dérivation (16) s'étendent dans différents plans de conduction en dessous et/ou au-dessus du plan de mesure des capteurs de gradient magnétorésistifs (14) et des conducteurs électriques (12), et que les conducteurs de dérivation (16) s'étendent essentiellement dans le plan des conducteurs électriques (12) et parallèlement aux conducteurs électriques (12).

8. Dispositif de mesure de courant polyphasé (10, 20, 30, 40, 50, 60) selon une des revendications précédentes, **caractérisé en ce que** plusieurs conducteurs de dérivation (16) sont disposés horizontalement ou verticalement de manière à être voisins relativement au plan de mesure ou concentriquement dans le plan de mesure du capteur de gradient magnétorésistif (14).

9. Dispositif de mesure de courant polyphasé (10, 20, 30, 40, 50, 60) selon une des revendications précédentes, **caractérisé en ce que** le capteur de gradient magnétorésistif (14) comprend un dispositif de compensation de champ de préférence réglable.

10. Dispositif de mesure de courant polyphasé (10, 20, 30, 40, 50, 60) selon une des revendications précédentes, **caractérisé en ce que** les conducteurs électriques (12) et/ou les conducteurs de dérivation (16) sont compris individuellement ou ensemble dans une structure ferritique pour imposer un sens de flux magnétique.

11. Dispositif de mesure de courant polyphasé (10, 20, 30, 40, 50, 60) selon une des revendications précédentes, **caractérisé en ce que** sont compris trois conducteurs électriques (12) et deux capteurs de gradient magnétorésistifs (14).

**12.** Procédé de mesure de courant polyphasé, de préférence en utilisant un dispositif de mesure de courant polyphasé (10, 20, 30, 40, 50, 60) avec $N$ phases de courant selon une des revendications précédentes, sachant que $N$-1 capteurs de gradient magnétorésistifs (14) sont utilisés pour mesurer $N$ courants de conducteurs des $N$ phases de courant avec $N>2$, et pour déterminer une différence d'intensité de champ magnétique dans un plan de mesure entre des courants de conducteurs électriques (12) voisins, respectivement un capteur de gradient magnétorésistif (14) est disposé avec un plan de mesure entre deux conducteurs électriques (12) voisins, **caractérisé en ce que** pour supprimer une composante de champ continu des courants des deux conducteurs électriques (12) voisins, un courant de dérivation d'au moins un autre conducteur électrique (12) non directement voisin, de préférence des courants de dérivation de tous les autres conducteurs électriques (12) non directement voisins, sont conduits symétriquement au plan de mesure du capteur de gradient (14) magnétorésistif.

**13.** Procédé selon la revendication 12, **caractérisé en ce que** l'intensité du ou des courants de dérivation est réglée par une modification de la résistance d'une section (32) du conducteur électrique (12), contournée par le conducteur de dérivation (16).

**14.** Procédé selon la revendication 12 ou 13, **caractérisé en ce qu'**un dispositif de compensation de champ des capteurs de gradient magnétorésistifs (14) est réglable pour calibrer la plage de mesure.

**15.** Procédé selon une des revendications du procédé 12 à 14, **caractérisé en ce que** la courant de dérivation mesure moins de 20 %, de préférence moins de 10 % et notamment moins de 5 % du courant des conducteurs.

100 ↘   12   12   12

14   14

S1   S2

L1   L2   L3

Stand der Technik

Fig. 1

1

|/|

0   50   100   150   200   250   300   350

-1

[°]

Fig. 2

L1   L2   L3

1

L1-L2

|/|

0   50   100   150   200   250   300   350

-1

—— GRADIENT   [°]
---- GLEICHFELD

Fig. 3

Fig. 4

Fig. 5

A-A

Fig. 6

Fig. 7

Fig. 8a

Fig. 8b

Fig. 9

Fig. 10

Fig. 11

Fig. 12

Fig. 13

Fig. 14

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 19748550 A1
- EP 0874244 B1
- EP 0597404 A2
- DE 10043171 A1
- EP 3141913 A1